# EUROPEAN PATENT APPLICATION

(11) **EP 0 614 080 A2**
(43) Date of publication of application: **07.09.1994**
(21) Application number: 94301426.6
(22) Date of filing: 28.02.1994
(51) Int. Cl.: G01N 21/88, H01L 21/00

(54) **Apparatus for recognizing the shape of a semiconductor wafer**

(30) Priority: 05.03.1993 JP 45463/93
(71) Applicant: TOKYO SEIMITSU CO.,LTD., Mitaka-shi Tokyo (JP)
(72) Inventor: Nishida, Tetsuro, c/o Tokyo Seimitsu Co., Ltd., Mitaka-shi, Tokyo (JP)
(74) Representative: Jackson, Peter Arthur

(57) **Abstract**

The present invention provides an apparatus for recognizing the shape of a semiconductor wafer, capable of stably achieving accurate shape recognition without being affected by a circuit pattern formed on the semiconductor wafer. The shape recognizing apparatus in accordance with the present invention comprises an illuminating means (1) for illuminating a semiconductor wafer (100), an image pickup means (3) for picking up an image of the semiconductor wafer (100) and providing video signals representing the image, disposed so that specular light reflected by the semiconductor wafer (100) will not fall thereon, and a shape recognizing means (6) which processes the video signals to recognize the shape of the semiconductor wafer (100), a first polarizing means (7) is disposed on a light path along which the illuminating light emitted by the illuminating means (1) travels, and a second polarizing means (8) is placed on a path along which reflected light from the semiconductor wafer (100) travels toward the image pickup means (3).

## Description

The present invention relates to an apparatus for recognizing the shape of a semiconductor wafer, capable of automatically recognizing the shape of a semiconductor wafer when the semiconductor wafer is being processed on a dicing apparatus or the like to enable the dicing apparatus or the like to process and handle the semiconductor wafer accurately and efficiently according to the shape of the semiconductor wafer even if the semiconductor wafer is chipped or cracked.

After fabricating a plurality of semiconductor chips on the surface of a semiconductor wafer, the semiconductor wafer is subjected to inspection to inspect the semiconductor chips with an IC tester provided with a prober and to a dicing process on a dicing apparatus. In automatically processing the semiconductor wafer, the automatic process is designed to align the semiconductor wafer automatically on an assumption that the semiconductor wafer is circular. The following explanation will be made in connection with a dicing apparatus by way of example. The dicing apparatus, which cuts narrow grooves in the surface of the semiconductor wafer with a cutting blade rotating at a high speed, is widely used for cutting the semiconductor wafer into semiconductor chips.

The pattern of the semiconductor chips fabricated on the surface of the semiconductor wafer cannot be correctly positioned relative to the working position of the cutting blade by simply mounting the semiconductor wafer on the stage and hence the grooves cannot be accurately cut along desired lines on the semiconductor wafer without adjusting the position of the semiconductor wafer relative to the cutting blade. The position of the semiconductor wafer relative to the working position of the cutting blade is adjusted by moving the stage supporting the semiconductor wafer into the field of view of an image pickup device and bringing a specified position on the semiconductor wafer into alignment with a specified position in the field of view of a projector. The projector is located beforehand at a predetermined position relative to the working position of the cutting blade. After thus determining the positional relation between the specified position on the surface of the semiconductor wafer and the working position of the cutting blade, the stage is moved by a precision stage moving mechanism to cut grooves accurately along the desired lines on the semiconductor wafer. The operation to adjust the position of the semiconductor wafer relative to the working position of the cutting blade is called an alignment operation.

When carrying out the alignment operation, for example, an image represented by the video signals provided by the TV camera is displayed on the screen of a monitor and the operator adjusts the position of the semiconductor wafer while observing the image displayed on the screen of the monitor. Recently, the automation of the dicing apparatus has been desired for the enhancement of productivity and the automation of the alignment operation has been realized. The automation of the alignment operation can be achieved by image processing the video signals provided by the TV camera.

When carrying out automatic alignment through image processing, specific points on the wafer are brought into the field of view of the TV camera, and the boundaries between the lines and the rows of the semiconductor chips are detected. Then, the inclination and the position of the lines and rows of the semiconductor chips are determined on the basis of the results of detection, the stage is turned so that the lines and rows of the semiconductor chips are aligned with the axes of the moving mechanism, and the coordinates of the moving mechanism in a state where the specified position on the semiconductor wafer coincides with a specified position on the image formed by the TV camera are stored in a memory. The identification of the lines and the rows of the semiconductor chips using the specific points can be achieved by a known pattern matching method or the like. Accordingly, when the specific points are brought into the field of view of the TV camera for identification, the identification of the lines and the rows of the semiconductor chips requires a comparatively short time if the specific points are positioned near the center of the field of view of the TV camera. If the specific points are located away from the center of the field of view of the TV camera, the automatic alignment operation requires a comparatively long time because the operation for pattern matching must be repeated many times.

The semiconductor wafer has a circular or substantially circular shape. Therefore, the specific points are moved for the automatic alignment operation to move the specific points into the field of view of the TV camera on an assumption that the semiconductor wafer is circular, the semiconductor wafer is supported on the frame with its center substantially on the center of the frame and the direction of extension of the lines of the semiconductor chips is within a certain range relative to notches formed in the frame. The pattern matching operation is performed when the semiconductor wafer is thus positioned.

In manufacturing processes, some semiconductor wafers are cracked or chipped, and the semiconductor wafer is not necessarily supported on the frame with its center in coincidence with the center of the frame. The yield rate of the process will be reduced if cracked semiconductor wafers and chipped semiconductor wafers are thrown away. Therefore, defective semiconductor wafers must be diced to provide normal semiconductor chips. However, when adjusting the position of a cracked semiconductor wafer by automatic alignment operation, the automatic identification of the lines and rows on the semiconductor chips is impossible because positions for identifying the lines and rows of the semiconductor chips cannot be determined, and a part of the semiconductor wafer not provided with any lines and rows of semiconductor chips may be brought into the field of view. When the center of the semiconductor wafer is located far away from the center of the frame, it is again impossible to identify the lines and rows on the semiconductor chips.

The applicant of the present patent application disclosed a dicing apparatus which starts its operation after recognizing the shape of the semiconductor wafer in Japanese Unexamined Patent Publication (Kokai) No. 4-109652. A dicing apparatus capable of recognizing the shape of the semiconductor wafer by image processing is disclosed in Japanese Unexamined Patent Publication (Kokai) No. 4-233250. In the dicing apparatus mentioned above, an image pickup device is disposed so that the specularly reflected light will not fall thereon. Since the surface of the semiconductor wafer is a highly accurate flat plane, most part of the illuminating light falling on the surface of the semiconductor wafer 100 is specularly reflected and little reflected light falls on the image pickup device and hence a region in the image corresponding to the semiconductor wafer is very dark. Although the flatness of the surface of the frame is not as high as that of the surface of the semiconductor wafer 100, a region in the image corresponding to the frame is somewhat dark because the surface of the frame has a comparatively high flatness. Since the surface of the adhesive sheet reflects the illuminating light irregularly, a region in the image corresponding to the surface of the adhesive sheet is bright. Accordingly, when processing the image to recognize the shape of the semiconductor wafer, the image is converted into a digital image by converting the brightness values of the image into digital values with reference to an appropriate threshold.

Sometimes, the region in the image corresponding to the surface of the semiconductor wafer is brighter than the region of the same corresponding to the surface of the adhesive sheet when the surface of the semiconductor wafer is in a particular condition. In such a case, the image data is inverted so that the images of bright surfaces are dark and the images of dark surfaces are bright, and then, the inverted image data is processed in the foregoing manner to recognize the shape of the semiconductor wafer.

Once the shape of the semiconductor wafer is recognized, the automatic alignment operation is possible because the positions of the lines and the rows of the semiconductor chips can be specified, and useless machining time can be dispensed with when dicing the semiconductor wafer because only part of the semiconductor wafer needs to be cut for dicing.

Some circuit patterns formed on the surface of the semiconductor wafer interfere with the perfect specular reflection of the incident illuminating light and causes part of the reflected light to fall on the image pickup device, which is inferred to be due to the diffraction of the light. If such a phenomenon occurs, the TV camera provides video signals representing a partly bright image of the semiconductor wafer. If the such image is digitized using the same threshold as that used for digitizing the image, the semiconductor wafer is recognized as a cracked semiconductor wafer and an accurate recognition of the shape of the semiconductor wafer is impossible.

A warp in the wafer and irregularly finished surface of the wafer are other effects that make accurate shape recognition impossible.

The present invention has been made in view of the foregoing problems and it is therefore an object of the present invention to provide a shape recognizing apparatus, for recognizing the shape of a semiconductor wafer, capable of stably and accurately recognizing the shape of a semiconductor wafer without being affected by the circuit pattern formed on the semiconductor wafer, a warp in the semiconductor wafer or the finish on the surface of the semiconductor wafer.

The shape recognizing apparatus in accordance with the present invention comprises: an illuminating means for illuminating a semiconductor wafer; an image pickup means disposed so that the light specularly reflected by the semiconductor wafer will not directly fall thereon, and capable of picking up the image of the semiconductor wafer and of providing video signals representing the image; and a means for recognizing the shape of the semiconductor wafer by processing the video signals; wherein a first polarizing means is placed on an optical path along which the illuminating light emitted by the illuminating means travels, and a second polarizing means is placed on an optical path along which the light from the semiconductor wafer travels toward and falls on the image pickup means.

In case part of the illuminating light is reflected toward the image pickup device by the circuit pattern formed on the semiconductor wafer, the polarizing direction of the reflected light has a specific angle depending on the surface condition of the circuit pattern of the semiconductor wafer. Accordingly, most part of the light reflected by the circuit pattern formed on the semiconductor wafer toward the image pickup device is intercepted by the second polarizing means when the illuminating light is polarized by the first polarizing means, and the polarizing direction of the second polarizing means is inclined at a given angle to the polarizing direction of the first polarizing means. Since the reflected light reflected by the adhesive sheet has random polarizing directions due to irregular reflection even if the incident illuminating light is polarized, the second polarizing means does not intercept all the reflected light. Accordingly, the shape recognizing apparatus in accordance to the present invention forms an image to achieve accurate shape recognition even if part of the illuminating light is reflected toward the image pickup device by the circuit pattern formed on the semiconductor wafer.

The present invention will be more clearly understood from the description as set forth below with reference to the accompanying drawings, wherein:
Fig. 1 is a perspective view of assistance in explaining the fundamental constitution of a dicing apparatus;
Fig. 2 is a plan view of a semiconductor wafer held on an adhesive sheet attached to a frame for dicing on a dicing apparatus, showing pattern recognition positions for automatic alignment;
Figs. 3A and 3B are schematic plan views showing a cracked or chipped semiconductor wafer having an abnormal shape and a semiconductor wafer supported on a frame at an incorrect position relative to the frame;
Fig. 4 is a perspective view of an arrangement for picking up an image of a semiconductor wafer for shape recognition;
Figs. 5A and 5B are plan views of images of semiconductor wafers formed by the arrangement shown in Fig. 4;
Fig. 6 is a perspective view of a dicing apparatus incorporating a shape recognizing apparatus in a preferred embodiment according to the present invention;
Fig. 7 is a diagrammatic view of assistance in explaining optical paths along which light travels when picking up an image of a semiconductor wafer by the shape recognizing apparatus embodying the present invention.

Before proceeding to a detailed description of the preferred embodiments of the present invention, prior art shape-recognizing apparatuses will be described, with reference to the accompanying drawings relating thereto,.for a clearer understanding of the differences between the prior art and the present invention. In the accompanying drawings, like or corresponding functional parts are denoted by the same reference characters and repetitive description thereof will be omitted.

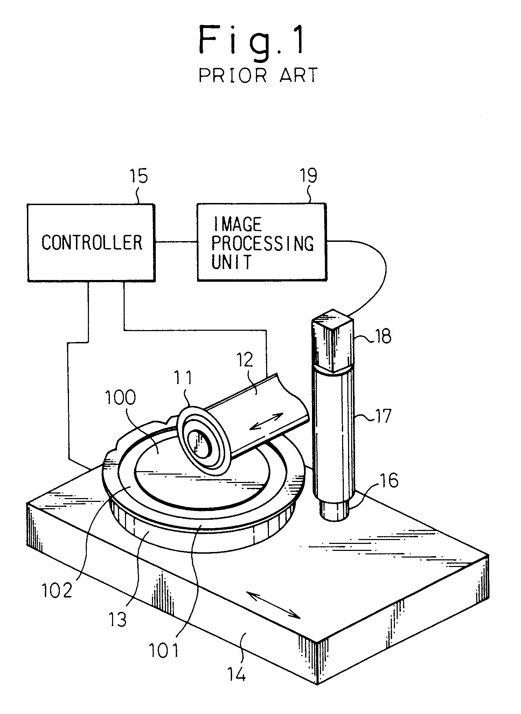

Fig. 1 is a perspective view showing the fundamental constitution of a dicing apparatus.

In Fig. 1, reference 100 indicates a semiconductor wafer to be diced; 11 indicates a cutting blade formed by bonding abrasive grains of diamond or the like with nickel or the like; 12 indicates a spindle motor holding the cutting blade 11 to rotate the cutting blade 11 at a high speed; 13 indicates a stage for fixedly supporting the semiconductor wafer 100 thereon by suction; 14 indicates a precision stage moving mechanism for moving the stage in the directions of the arrows, and 16, 17 and 18 indicate components including in an image pickup device for measuring the position of the semiconductor wafer 100 supported on the stage 13. The stage 13 supporting the semiconductor wafer 100 is moved relative to the rotating cutting blade 11 for dicing.

Although the semiconductor wafer 100 may directly be held on the stage 13, it is usual to attach the semiconductor wafer 100 to an adhesive sheet and to hold the adhesive sheet fixedly on the stage 13 to prevent the semiconductor wafer 100 from breaking into pieces during dicing. When thus holding the semiconductor wafer 100 on the stage 13, an adhesive sheet 102 is attached to a frame 101 having a central opening formed by punching, the semiconductor wafer 100 is attached to the adhesive surface of the adhesive sheet 102 exposed in the central opening of the frame 101, and the frame 101 thus holding the semiconductor wafer 100 is fixedly mounted on the stage 13. The frame 101 thus holding the semiconductor wafer 100 is transported between processing stations.

The image pickup device comprises an objective 16 which forms an enlarged image of the surface of the semiconductor wafer 100, a lens barrel 17 and a TV camera 18. The image pickup device provides video signals representing an enlarged image of the surface of the semiconductor wafer 100. As previously described, the pattern of the semiconductor chips fabricated on the surface of the semiconductor wafer 100 cannot be correctly positioned relative to the working position of the cutting blade 11 by simply mounting the semiconductor wafer 100 on the stage 13 and hence the alignment operation is performed. In the alignment operation, the position of the semiconductor wafer 100 relative to the working position of the cutting blade 11 is adjusted by moving the stage 13 supporting the semiconductor wafer 100 into the field of view of the image pickup device and bringing a specified position on the semiconductor wafer 100 into alignment with a specified position in the field of view of a projector.

The projector is located beforehand at a predetermined position relative to the working position of the cutting blade 11. After thus determining the positional relationship between the specified position on the surface of the semiconductor wafer 100 and the working position of the cutting blade 11, the stage 13 is moved by the precision stage moving mechanism 14 to accurately cut grooves on the semiconductor wafer 100.

Recently, automation of the dicing apparatus has been desired to enhance productivity and automation of the alignment operation has been realized. Automation of the alignment operation can be achieved by image processing the video signals provided by the TV camera 18.

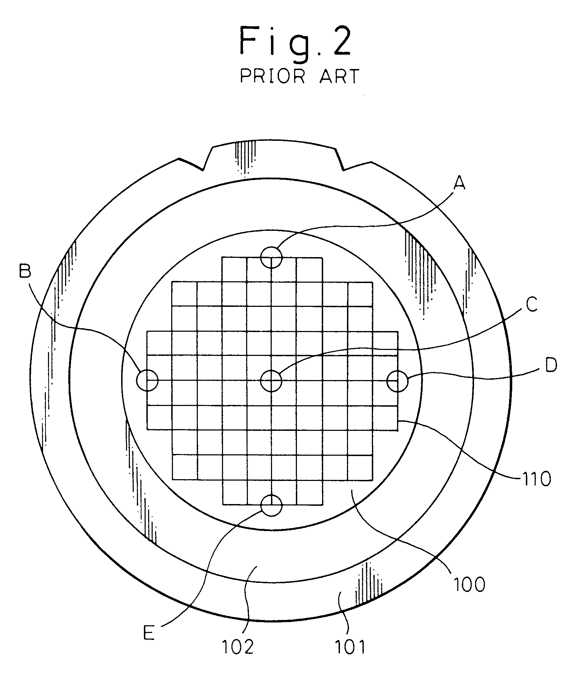

Fig. 2 is a plan view of a semiconductor wafer 100 held on an adhesive sheet 102 attached to a frame 101 for dicing on a dicing apparatus. As shown in Fig. 2, a plurality of semiconductor chips 110 are fabricated on the semiconductor wafer 100 in a predetermined arrangement, and grooves are to be cut between the rows and lines of the semiconductor chips 110. When carrying out automatic alignment through image processing, points A to E are brought into the field of view of the TV camera 18, and the boundaries between the lines and the rows of the semiconductor chips 110 are detected. Then, the inclination and the position of the lines and rows of the semiconductor chips 110 are determined on the basis of the results of detection, the stage 13 is turned so that the lines and rows of the semiconductor chips 110 are aligned with the axes of the moving mechanism, and the coordinates of the moving mechanism, in a state where the specified position on the semiconductor wafer 100 coincides with a specified position on the image formed by the TV camera 18, are stored in a memory. The identification of the lines and the rows of the semiconductor chips 110 using the points A to E can be achieved by a known pattern matching method or the like. Accordingly, when the points A to E are brought into the field of view of the TV camera 18 for identification, the identification of the lines and the rows of the semiconductor chips 110 requires a comparatively short time if the points A to E are positioned near the center of the field of view of the TV camera 18. If the points A to E are located far from the center of the field of view of the TV camera 18, the automatic alignment operation requires a comparatively long time because the operation for pattern matching must be repeated many times.

The semiconductor wafer has a circular or substantially circular shape. Therefore, the points A to E shown in Fig. 2 are moved, during the automatic alignment operation, into the field of view of the TV camera 18 on an assumption that the semiconductor wafer 100 is circular, the semiconductor wafer 100 is supported on the frame 101 with its center substantially on the center of the frame 101 and the direction of extension of the lines of the semiconductor chips 110 is within a certain range relative to notches formed in the frame 101. The pattern matching operation is performed when the semiconductor wafer 100 is thus positioned.

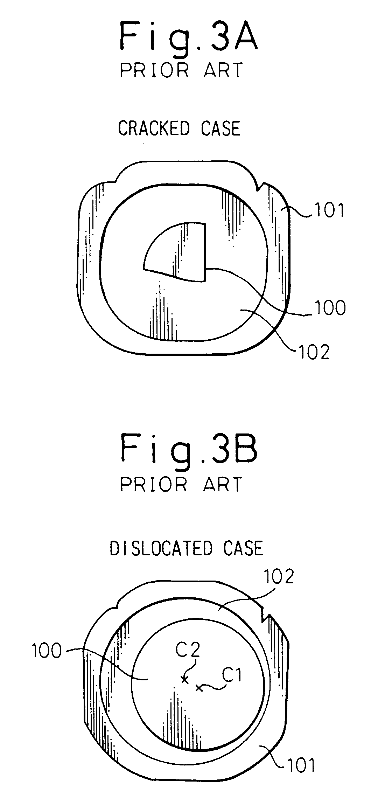

In the industrial manufacturing process, some semiconductor wafers are cracked or chipped, and the semiconductor wafer is not necessarily supported on the frame with its center in coincidence with the center of the frame. Figs. 3A and 3B show a semiconductor wafer having an abnormal shape and a semiconductor wafer not correctly supported on the frame, respectively. The yield rate of the process will be reduced if cracked semiconductor wafers and chipped semiconductor wafers are thrown away. Therefore, defective semiconductor wafers must be diced, to provide normal semiconductor chips, like a semiconductor wafer 100 shown in Fig. 3A.

However, when adjusting the position of the cracked semiconductor wafer 100 as shown in Fig. 3A by automatic alignment operation, the automatic identifications of the lines and rows of the semiconductor chips is impossible because the positions for identifying the lines and rows of the semiconductor chips can not be determined, and part of the semiconductor wafer 100 not provided with any lines and rows of semiconductor chips is brought into the field of view. When the center C1 of the semiconductor wafer 100 is dislocated greatly from the center C2 of the frame 101 as shown in Fig. 3B, it is again impossible to identify the lines and the rows of the semiconductor chips.

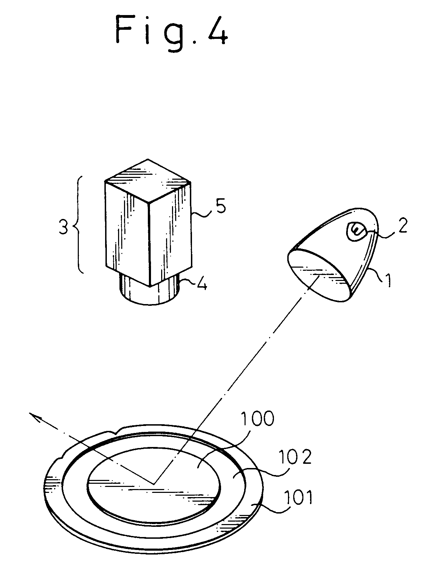

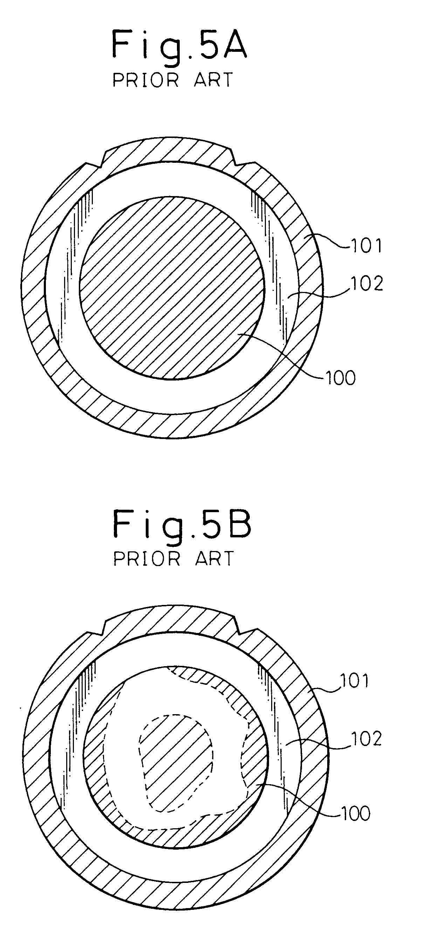

Fig. 4 is a diagram showing a fundamental arrangement for detecting the shape of a semiconductor wafer using a TV camera. In Fig. 4, reference 1 indicates an illuminating device having a lamp 2 for illuminating a semiconductor wafer 100, and 3 indicates an image pickup system consisting of a lens unit 4 and a TV camera 5. Illuminating light emitted by the illuminating device 1 falls obliquely on the surface of the semiconductor wafer 100, and the image pickup device 3 is directed perpendicularly to the surface of the semiconductor wafer 100 to pick up the image of the semiconductor wafer 100. The image pickup device 3 is disposed so that the specularly reflected light will not fall thereon. If the semiconductor wafer 100 is in the normal state, the TV camera provides video signals representing an image as shown in Fig. 5A. Since the surface of the semiconductor wafer 100 is a highly accurate flat plane, most part of the illuminating light falling on the surface of the semiconductor wafer 100 is specularly reflected and little reflected light falls on the image pickup device 3 and hence a region in the image corresponding to the semiconductor wafer 100 is very dark. Although the flatness of the surface of the frame 101 is not as high as that of the surface of the semiconductor wafer 100, a region in the image corresponding to the frame 101 is somewhat dark because the surface of the frame 101 has a comparatively high flatness. Since the surface of the adhesive sheet 102 reflects the illuminating light irregularly, a region in the image corresponding to the surface of the adhesive sheet 102 is bright. Accordingly, when processing the image to recognize the shape of the semiconductor wafer 100, the image is converted into a digital image by converting the brightness values of the image into digital values with reference to an appropriate threshold.

Sometimes, the region in the image corresponding to the surface of the semiconductor wafer is brighter than the region corresponding to the surface of the adhesive sheet when the surface of the semiconductor wafer is in a particular condition. In such a case, the image data is inverted so that the images of bright surfaces are dark and the images of dark surfaces are bright, and then, the inverted image data is processed in the foregoing manner to recognize the shape of the semiconductor wafer.

Once the shape of the semiconductor wafer 100 is recognized, the automatic alignment operation is possible because the positions for recognizing the lines and the rows of the semiconductor chips can be specified, and the useless machining time can be dispensed with when dicing the semiconductor wafer 100 because only necessary parts of the semiconductor wafer 100 need to be cut for dicing.

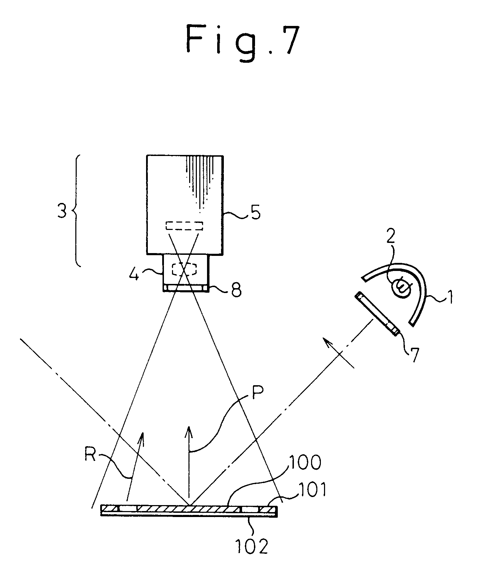

As previously described, some circuit pattern formed on the surface of the semiconductor wafer 100 interfere with the perfect specular reflection of the incident illuminating light and causes part of the reflected light to fall on the image pickup device 3, which is inferred to be due to the diffraction of the light. If such a phenomenon occurs, the TV camera 5 provides video signals representing a partly bright image of the semiconductor wafer as shown in Fig. 5B. If the image as shown in Fig. 5B is subjected to digitization using the same threshold as that used for digitizing the image as shown in Fig. 7A, the semiconductor wafer 100 is recognized as a cracked semiconductor wafer and an accurate recognition of the shape of the semiconductor wafer 100 is impossible.

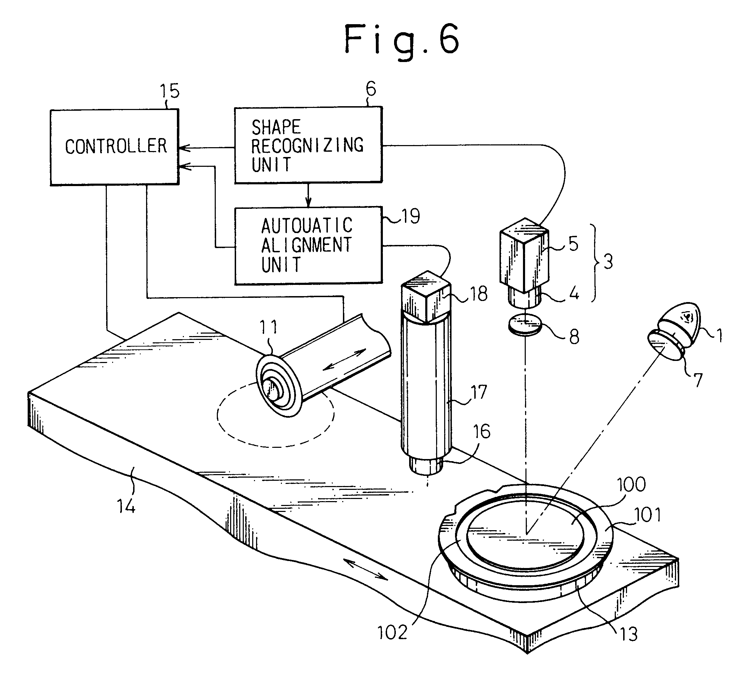

Fig. 6 is a perspective view of a dicing apparatus incorporating a shape recognizing apparatus in a preferred embodiment according to the present invention.

In Fig. 6, indicated at 11 is a cutting blade, and at 12 is a spindle motor for rotating the cutting blade 11 at a high rotating speed, capable of being moved in the directions of the arrows. A stage 13 for holding a semiconductor wafer 100 to be subjected to dicing is moved in the directions of the arrows by a stage moving mechanism 14. Moving mechanisms for moving the spindle motor 12 and the stage 13 are controlled by a controller 15. The semiconductor wafer 100 is attached to an adhesive sheet 102 attached to the frame 101 shown in Fig. 2, and the frame 101 holding the semiconductor wafer 100 is mounted on the stage 13. An image pickup device for forming an image of the semiconductor wafer 100 for the automatic alignment operation comprises a microscopic lens unit 16, a lens barrel 17 and a TV camera 18. In Fig. 6, an illuminating device is not shown. The microscopic lens unit 16 forms enlarged images of the semiconductor wafer 100, the frame 101 and the adhesive sheet 102 on the TV camera 18, and then the TV camera 18 provides video signals representing the enlarged images. An automatic alignment unit 19 processes the video signals to identify a circuit pattern formed on the semiconductor wafer 100 and calculates the inclination of the circuit pattern relative to the screen and the position of the circuit pattern. The controller 15 turns the stage 13 to bring the lines of semiconductor chips into alignment with the axis of the stage moving mechanism 14 and moves the stage 13 to bring a specified position on the circuit pattern into coincidence with the center of the screen on the basis of calculated values provided by the automatic alignment unit 19. In this state, the controller 15 stores the coordinates-of the stage moving mechanism 14 as origin and controls the operation of the stage moving mechanism 14.

The shape recognizing apparatus comprises an illuminating device 1 for illuminating the semiconductor wafer 100 when picking up an image of the semiconductor wafer 100 for shape recognition, an image pickup device 3, a shape recognizing unit 6 carries out image processing on the basis of video signals provided by the image pickup device 3 to recognize the shape of the semiconductor wafer 100, a first polarizing filter 7, and a second polarizing filter 8.

Fig. 7 is a diagram showing optical paths along which light travels when picking up an image of the semiconductor wafer 100 using the shape recognizing apparatus. In Fig. 7, reference 2 indicates the lamp, i.e., the light source, of the illuminating device, 4 indicates the objective of the image pickup device 3, and 5 indicates a TV camera.

The optical paths shown in Fig. 7 will be described hereinafter. Suppose that the polarizing direction of the first polarizing filter 7 is parallel to the paper. The illuminating light is reflected by the circuit pattern formed on the semiconductor wafer 100 and the reflected light P travels toward the-image pickup device 3. The polarizing direction of the reflected light has a specific angle which is dependent on the surface condition of the semiconductor wafer 100. Accordingly, most of the reflected light P is intercepted by the second polarizing filter having a polarizing direction perpendicular to the specified angle. Reflected light R reflected by the adhesive sheet 102 is irregularly reflected light and has random polarizing directions. Accordingly, half the reflected light R is intercepted by the second polarizing filter 8 and the rest passes through the second polarizing filter 8. Therefore, the image of the adhesive sheet 102 is brighter than that of the semiconductor wafer 100. Since most of the light reflected toward the image pickup device 3 by the semiconductor wafer 100 is intercepted, no bright region will be formed in the image of the semiconductor wafer 100 even if reflectance varies from region to region on the surface of the semiconductor wafer 100. Consequently, the respective images of the semiconductor wafer 100 and the adhesive sheet 102 contrast sharply and hence accurate shape recognition can be achieved.

In this shape recognition apparatus, the respective polarizing directions of the first polarizing filter 7 and the second polarizing filter 8 are substantially perpendicular to each other. However, the polarizing direction of the second filter 8 may be changed relative to the polarizing direction of the first filter 7 to adjust the brightnesses of the images so that accurate shape recognition can be achieved on the basis of the images.

As is apparent from the foregoing description, the shape recognizing apparatus for a semiconductor wafer in accordance with the present invention uses polarized illuminating light for illuminating the semiconductor wafer, and uses a polarizing filter for intercepting the reflected light reflected directly toward the image pickup device and, therefore, part of the reflected light directly reflected by the circuit pattern varying in reflectance from region to region is intercepted and, consequently, stable, accurate shape recognition can be achieved.

## Claims

1. A shape recognizing apparatus for recognizing the shape of a semiconductor wafer, comprising:
an illuminating means (1) for illuminating a semiconductor wafer (100);
an image pickup means (3) disposed so that the light specularly reflected by the semiconductor wafer (100) will not directly fall thereon, and capable of picking up the image of the semiconductor wafer (100) and of providing video signals representing the image; and
a shape recognizing means (6) for recognizing the shape of the semiconductor wafer (100) by processing the video signals;
characterized in that said apparatus comprises:
a first polarizing means (7) placed on an optical path along which illuminating light emitted by the illuminating means (1) travels; and
a second polarizing means (8) placed on an optical path along which the light from the semiconductor wafer (100) travels toward the image pickup means (3).

2. A shape recognizing apparatus for recognizing the shape of a semiconductor wafer, comprising:
an illuminating means (1) that emits light for illuminating a semiconductor wafer (100);
an image pickup means (3) disposed so that the light specularly reflected by the semiconductor wafer (100) will not directly fall thereon, and capable of picking up an image of the semiconductor wafer (100) and of providing video signals representing the image: and
a shape recognizing means (6) for recognizing the shape of the semiconductor wafer (100) by processing the videosignals;
characterized in that said illuminating means (1) emits polarized light; and
said apparatus comprises a polarizing means (8) placed on an optical path along which the light from the semiconductor wafer (100) travels toward the image pickup means (3).
